# EUROPEAN PATENT APPLICATION

(11) **EP 4 852 317 A1**
(43) Date of publication of application: **09.12.2026**
(21) Application number: 25769760.7
(22) Date of filing: 14.03.2025
(51) Int. Cl.: H03F 3/45

(54) **COMMON-BASE AMPLIFICATION CIRCUIT, RADIO-FREQUENCY AMPLIFIER, AND ELECTRONIC DEVICE**

(30) Priority: 14.03.2024 CN 202410294640
(71) Applicant: Sanechips Technology Co., Ltd., Shenzhen, Guangdong 518055 (CN)
(72) Inventor: LI, Xingcun, Shenzhen, Guangdong 518055 (CN); GUO, Kuantian, Shenzhen, Guangdong 518055 (CN)
(74) Representative: Canzler & Bergmeier Patentanwälte Partnerschaft mbB
(86) International application number: PCT/CN2025/082544
(87) International publication number: WO 2025/190382

(57) **Abstract**

A common-base amplification circuit, a radio-frequency amplifier, and an electronic device. The common-base amplification circuit comprises: a first transistor, a second transistor and a decoupling unit, wherein a base electrode of the first transistor is connected to a base electrode of the second transistor; and the decoupling unit is connected between the base electrode of the first transistor and the base electrode of the second transistor, and is used for decoupling and adjusting odd harmonics and even harmonics. The decoupling unit is connected between the base electrodes of the first transistor and the second transistor, which have a common base electrode, such that odd harmonic components and even harmonic components can be independently adjusted, and harmonic control can be implemented without the need for additional matching of input and output elements, thereby simplifying the circuit structure and improving the gain of useful signals; and the even harmonic components are independently adjusted, such that a common-mode component of the circuit can also be adjusted while ensuring that a differential-mode gain remains unchanged, thereby enhancing common-mode suppression and improving the common-mode stability and comprehensive performance of a radio-frequency amplifier.

## Description

### CROSS REFERENCE TO RELATED APPLICATIONS

The present disclosure claims the priority to Chinese Patent Application No. CN202410294640.1 entitled "COMMON-BASE AMPLIFICATION CIRCUIT, RADIO-FREQUENCY AMPLIFIER, AND ELECTRONIC DEVICE" and filed with the CNIPA on March 14, 2024, the contents of which are incorporated herein by reference in their entirety.

### TECHNICAL FIELD

Embodiments of the present disclosure relate to, but are not limited to, the technical field of wireless communication, and in particular, to a common-base amplification circuit, a radio-frequency amplifier, and an electronic device.

### BACKGROUND

With the continuous development of mobile communication, the fifth-generation (5G) mobile communication proposes higher requirements on transmission rate, latency, and reliability. A cascode (common-source common-gate or common-emitter common-base) amplification structure with high gain, high isolation, and high output voltage swing becomes a commonly used structure in various amplifiers of radio frequency transceivers. Stability of the amplifiers is a top-priority index for various amplifiers, and other additional indexes are meaningful on the premise of stability. Common-mode stability of a differential radio-frequency amplifier is one of the most important indexes. Performance of a radio-frequency amplifier with poor common-mode stability may be severely affected by signals on common mode nodes such as a power supply and the ground, such that the performance of the radio-frequency amplifier is greatly changed, and even oscillation is caused. In addition, each harmonic component on each node of the amplifier has a certain influence on output power, efficiency, and linearity of the amplifier, and there are also high requirements on harmonic spurs in a frequency conversion system. Therefore, regulating harmonics in the amplifier is one of the key technologies for improving the performance.

A radio-frequency amplifier with the conventional cascode structure has the problem of poor common-mode stability of circuit. A radio-frequency amplifier with a conventional stack structure has the problem that all harmonics are affected when cas capacitance changes, resulting in limitation to harmonic suppression capability. For amplifiers such as a Local Oscillator Driver Amplifier (LODA) and a non-linear Power Amplifier (PA), harmonic regulation cannot be performed without additionally matching input and output elements.

### SUMMARY

The present disclosure provides a common-base amplification circuit, a radio-frequency amplifier, and an electronic device.

In a first aspect, an embodiment of the present disclosure provides a common-base amplification circuit, including: a first transistor, a second transistor, and a decoupling unit, wherein a base of the first transistor is connected to a base of the second transistor; the decoupling unit is connected between the base of the first transistor and the base of the second transistor, and is configured to decouple and adjust odd harmonics and even harmonics.

In another aspect, an embodiment of the present disclosure further provides a radio-frequency amplifier, including the above common-base amplification circuit.

In yet another aspect, an embodiment of the present disclosure further provides an electronic device, including the above radio-frequency amplifier.

### BRIEF DESCRIPTION OF DRAWINGS

FIG. 1a is a schematic diagram of a radio-frequency amplifier with a cascode structure in the related technology;
FIG. 1b is a schematic diagram of a radio-frequency amplifier with a stack structure in the related technology;
FIG. 2 is a block diagram of a common-base amplification circuit according to an embodiment of the present disclosure;
FIG. 3a is a schematic structural diagram of a common-base amplification circuit including a π-type decoupling unit according to an embodiment of the present disclosure;
FIG. 3b is a schematic structural diagram of a common-base amplification circuit including a T-type decoupling unit according to an embodiment of the present disclosure;
FIG. 4 is a block diagram of a radio-frequency amplifier according to an embodiment of the present disclosure;
FIG. 5 is a block diagram of a radio-frequency amplifier according to an embodiment of the present disclosure;
FIG. 6a is a schematic diagram of a radio-frequency amplifier with a cascode structure according to an embodiment of the present disclosure;
FIG. 6b is a schematic diagram of a radio-frequency amplifier with a stack structure according to an embodiment of the present disclosure;
FIG. 7 is a schematic structural diagram of a radio-frequency amplifier with a cascode structure according to a specific example of the present disclosure;
FIG. 8 is a schematic diagram illustrating variation of a differential-mode gain of the radio-frequency amplifier of FIG. 7 with an adjustment coefficient;
FIG. 9 is a schematic diagram illustrating variation of common-mode stability factors of the radio-frequency amplifier of FIG. 7 with an adjustment coefficient;
FIG. 10 is a schematic diagram illustrating variation of harmonics with input power under different adjustment coefficients in the radio-frequency amplifier of FIG. 7;
FIG. 11 is a schematic diagram illustrating variation of OP1dB of the radio-frequency amplifier of FIG. 7 with an adjustment coefficient;
FIG. 12 is a schematic diagram illustrating variation of OP3dB of the radio-frequency amplifier of FIG. 7 with an adjustment coefficient.

### DETAIL DESCRIPTION OF EMBODIMENTS

Exemplary embodiments will be described more fully below with reference to the drawings, but the exemplary embodiments may be embodied in different forms and should not be interpreted as being limited to the embodiments described herein. Rather, the embodiments are provided to make the present disclosure thorough and complete, and are intended to enable those of ordinary skill in the art to fully understand the scope of the present disclosure.

The term "and/or" used herein includes any and all combinations of one or more associated listed items.

The terms used herein are merely used to describe specific embodiments, and are not intended to limit the present disclosure. As used herein, "a" and "the" which indicate a singular form are intended to include a plural form, unless expressly stated in the context. It should be further understood that the terms "include" and/or "be made of" used herein indicate the presence of the described features, integers, operations, elements and/or components, but do not exclude the presence or addition of one or more other features, integers, operations, elements, components and/or combinations thereof.

The embodiments described herein can be described with reference to plans and/or cross-sectional views with the aid of idealized schematic diagrams of the present disclosure. Accordingly, the exemplary drawings may be modified according to manufacturing techniques and/or tolerances. Therefore, the embodiments are not limited to those illustrated by the drawings, but include modifications to configuration formed based on a manufacturing process. Thus, regions shown in the drawings are illustrative, and shapes of the regions shown in the drawings illustrate specific shapes of regions of elements, but are not intended to make limitations.

Unless otherwise defined, all terms (including technical and scientific terms) used herein have the same meaning as commonly understood by those of ordinary skill in the art. It should be further understood that terms, such as those defined in commonly used dictionaries, should be interpreted as having a meaning that is consistent with a meaning in the related technology and the background of the present disclosure, and should not be interpreted in an idealized or overly formal sense unless expressly so defined herein.

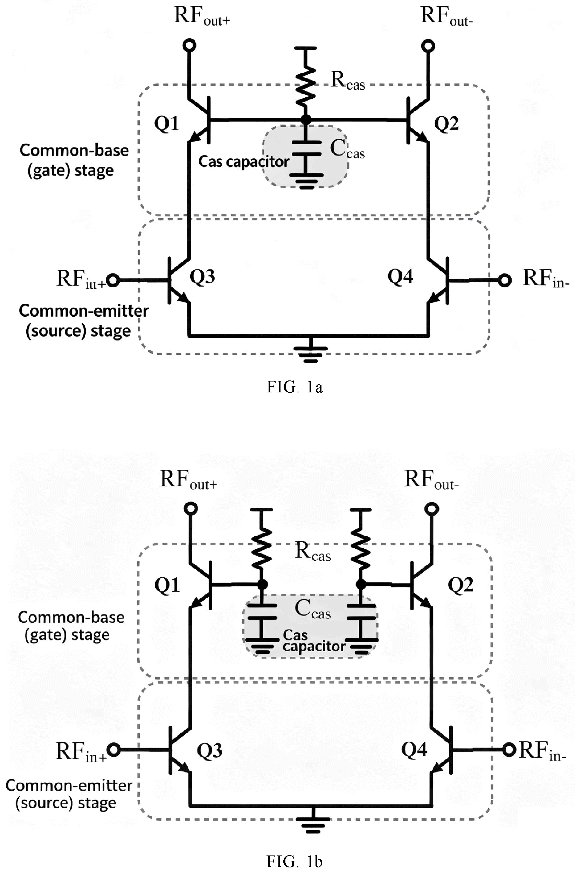

Conventional differential radio-frequency amplifiers can be classified into a cascode structure and a stack structure based on common-base stage base capacitor connection and common-gate stage gate capacitor connection. A circuit of a differential radio-frequency amplifier with the cascode structure is as shown in FIG. 1a. A circuit of a differential radio-frequency amplifier with the stack structure is as shown in FIG. 1b. Each of the cascode structure and the stack structure includes a common emitter (source) stage, a common base (gate) stage, and a cas capacitor. The conventional radio-frequency amplifiers have the following disadvantages: in the cascode structure, a virtual ground can provide an ideal differential alternating current ground, differential-mode gain is high, and a relatively large cas capacitor which is generally connected in parallel with bases of Q3 and Q4 provides power supply filtering, but common-mode stability of the circuit is reduced; in the stack structure, a cas capacitor provides a radio frequency alternating current ground, and gain control of the amplifier can be realized by adjusting a cas capacitance value, but all harmonics are affected when the cas capacitance value changes, and odd harmonic component and even harmonic component cannot be decoupled for independent adjustment. In the related technology, harmonic regulation of the radio-frequency amplifiers is usually performed in input and output matching networks, which may need additional matching elements, occupy more area, and increase loss of useful signals.

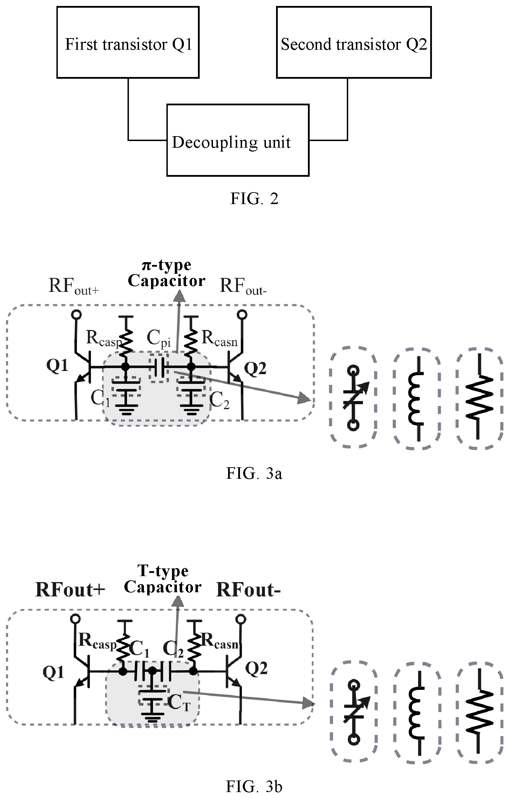

In order to solve the above problems, an embodiment of the present disclosure provides a common-base amplification circuit. As shown in FIG. 2, FIG. 3a, and FIG. 3b, the common-base amplification circuit includes a first transistor Q1, a second transistor Q2, and a decoupling unit, and a base of the first transistor Q1 is connected to a base of the second transistor Q2; the decoupling unit is connected between the base of the first transistor Q1 and the base of the second transistor, and is configured to decouple and adjust odd harmonics and even harmonics.

The common-base amplification circuit is applicable to a differential radio-frequency amplifier, an emitter of the first transistor Q1 and an emitter of the second transistor Q2 are connected to two output terminals of a common-emitter circuit in the radio-frequency amplifier respectively, the decoupling unit is connected in series between the base of Q1 and the base of Q2 and is grounded, and a collector of Q1 and a collector of Q2 are connected to two output terminals of the radio-frequency amplifier, i.e., RFout+ and RFout-. The first transistor Q1 and the second transistor Q2 have the same size, and may be bipolar transistors or field effect transistors.

By connecting the decoupling unit between the bases of the first transistor Q1 and the second transistor Q2 in common-base configuration, odd harmonic component and even harmonic component of the radio-frequency amplifier with the stack structure can be independently adjusted to realize decoupling and adjustment, harmonic regulation can be realized without additionally matching input and output elements, circuit structure is simplified, and useful signal gain is improved; moreover, by independently adjusting the even harmonic component, common-mode component of the circuit can be adjusted on the premise of ensuring that differential-mode gain is not changed, that is, the even harmonic component can be adjusted, enhancement of common-mode rejection can be realized, and common-mode stability and comprehensive performance of the radio-frequency amplifier can be improved.

In some embodiments, the decoupling unit includes a first impedance element, a second impedance element, and a third impedance element, which are arranged in a π configuration or a T configuration. That is, the decoupling unit may be a π-type decoupling unit or a T-type decoupling unit.

The decoupling unit is configured to adjust the odd harmonics by adjusting a target impedance parameter which is obtained based on an impedance parameter of the first impedance element, an impedance parameter of the second impedance element, and an impedance parameter of the third impedance element, and adjust, under the condition that the target impedance parameter is not changed, the even harmonics by adjusting a ratio of the impedance parameters of the first impedance element, the second impedance element, and the third impedance element.

In some embodiments, the first impedance element, the second impedance element, or the third impedance element may be one of or any combination of: a capacitor, an inductor, and a resistor; correspondingly, the impedance parameter may be a capacitance value, an inductance value, or a resistance value.

Taking impedance elements in the decoupling unit being a capacitor as an example, the decoupling unit adjusts the odd harmonics by adjusting an overall capacitance value of the decoupling unit, thereby achieving differential-mode adjustment; under the condition of ensuring that the overall capacitance value of the decoupling unit is not changed, the decoupling unit adjusts the even harmonics by adjusting a capacitance ratio of the three capacitance elements, that is, achieving common-mode adjustment with the differential mode unchanged.

One or more of the first impedance element, the second impedance element, and the third impedance element may be variable impedance elements or fixed impedance elements. Illustratively, in a case where the impedance elements are capacitors, one or more of the first impedance element, the second impedance element, and the third impedance element may be variable capacitors or capacitors with fixed capacitance values; in a case where the impedance elements are inductors, one or more of the first impedance element, the second impedance element, and the third impedance element may be variable inductors or inductors with fixed inductance values; in a case where the impedance elements are resistors, one or more of the first impedance element, the second impedance element, and the third impedance element may be variable resistors or resistors with fixed resistance values. By adopting the variable impedance elements, the ratio of the target impedance parameter to the impedance parameters of the impedance elements can be easily adjusted.

In some embodiments, the impedance parameter of the first impedance element is equal to that of the second impedance element. It should be noted that the impedance parameters of the first impedance element and the second impedance element may be set to be different in order to further improve the common-mode stability, so as to adjust balance of the radio-frequency amplifier.

Taking each impedance element being a capacitor as an example, a structure of the π-type decoupling unit is described in detail below with reference to FIG. 3a. In the π-type decoupling unit, the third impedance element is denoted by Cₚᵢ. As shown in FIG. 3a, the first impedance element C₁, the second impedance element C₂, and the third impedance element Cₚᵢ are arranged in a π configuration, one terminal (a first terminal) of the first impedance element C₁ is connected to the base of the first transistor Q1, and the other terminal (a second terminal) is grounded; one terminal (a first terminal) of the second impedance element C₂ is connected to the base of the second transistor Q2, and the other terminal (a second terminal) is grounded; the third impedance element Cₚᵢ is connected across the base of the first transistor Q1 and the base of the second transistor Q2. The first impedance element C₁, the second impedance element C₂, and the third impedance element Cₚᵢ may all high-Q variable capacitors or capacitor arrays, so as to realize digital control and multi-step adjustment.

It should be noted that the non-grounded terminal (i.e., the first terminal) of the first impedance element C₁ and the base of the first transistor Q1 are further connected to a first bias resistor Rcasp, the non-grounded terminal (i.e., the first terminal) of the second impedance element C₂ and the base of the second transistor Q2 are further connected to a second bias resistor Rcasn, and the first bias resistor Rcasp and the second bias resistor Rcasn are used for bias power supply.

In a case where the first impedance element C₁, the second impedance element C₂, and the third impedance element Cₚᵢ are capacitors, the following condition is met: Cₚᵢ=0.5*(1-α₁)*Cₜₒₜₐₗ ; where Cₜₒₜₐₗ is a capacitance value of the decoupling unit, Cₜₒₜₐₗ=C₁+2Cₚᵢ or Cₜₒₜₐₗ=C₂+2Cₚᵢ , and in general, C₁=C₂=α₁*Cₜₒₜₐₗ ; where Cₚᵢ is a capacitance value of the third impedance element, α₁ is a first adjustment coefficient, and α₁≠1.

When 0≤α₁<1, the first impedance element C₁, the second impedance element C₂, and the third impedance element Cₚᵢ all serve as capacitors; when α₁>1, the third impedance element Cₚᵢ is equivalent to an inductor, and the first impedance element C₁ and the second impedance element C₂ serve as capacitors; when α₁<0, the first impedance element C₁ and the second impedance element C₂ are equivalent to inductors, and the third impedance element Cₚᵢ serves as a capacitor.

The decoupling unit is configured to adjust the even harmonics by adjusting the first adjustment coefficient α₁ under the condition that the capacitance value of the decoupling unit is not changed. In this way, a ratio of C₁, C₂, and Cₚᵢ can be allocated with ensuring that the differential-mode Cₜₒₜₐₗ is not changed, and enhancement of common-mode rejection and adjustable harmonics of each order can be realized

Taking each impedance element being a capacitor as an example, a structure of the T-type decoupling unit is described in detail below with reference to FIG. 3b. In the T-type decoupling unit, the third impedance element is denoted by C_{T}. As shown in FIG. 3b, the first impedance element C₁, the second impedance element C₂, and the third impedance element C_{T} are arranged in a T configuration, one terminal (a first terminal) of the first impedance element C₁ is connected to the base of the first transistor Q1, and the other terminal (a second terminal) of the first impedance element C₁ is connected to one terminal (a first terminal) of the second impedance element C₂; the other terminal (a second terminal) of the second impedance element C₂ is connected to the base of the second transistor Q2; one terminal of the third impedance element C_{T} is connected between the first impedance element C₁ and the second impedance element C₂, and the other terminal is grounded. The first impedance element C₁, the second impedance element C₂, and the third impedance element C_{T} may all high-Q variable capacitors or capacitor arrays, so as to realize digital control and multi-step adjustment.

It should be noted that the first terminal of the first impedance element C₁ and the base of the first transistor Q1 are further connected to a first bias resistor Rcasp, the second terminal of the second impedance element C₂ and the base of the second transistor Q2 are further connected to a second bias resistor Rcasn, and the first bias resistor Rcasp and the second bias resistor Rcasn are used for bias power supply.

In a case where the first impedance element C₁, the second impedance element C₂, and the third impedance element C_{T} are capacitors, the following condition is met: C_{T}=α₂*Cₜₒₜₐₗ ; where Cₜₒₜₐₗ is a capacitance value of the decoupling unit; in general, C₁=C₂=Cₜₒₜₐₗ ; where C_{T} is a capacitance value of the third impedance element, and α₂ is a second adjustment coefficient.

When α₂>0, the first impedance element C₁, the second impedance element C₂, and the third impedance element C_{T} all serve as capacitors; when α₂<0, the third impedance element C_{T} is equivalent to an inductor.

The decoupling unit is configured to adjust the even harmonics by adjusting the second adjustment coefficient α₂ under the condition that the capacitance value of the decoupling unit is not changed. In this way, the capacitance value of the third impedance element can be adjusted with ensuring that the differential-mode gain is not changed, and the enhancement of common-mode rejection and the adjustable harmonics of each order can be realized.

An embodiment of the present disclosure further provides a radio-frequency amplifier, including the common-base amplification circuit as described above.

The radio-frequency amplifier provided in the embodiment of the present disclosure includes the common-base amplification circuit, the common-base amplification circuit includes the first transistor, the second transistor, and the decoupling unit, and the base of the first transistor is connected to the base of the second transistor; the decoupling unit is connected between the base of the first transistor and the base of the second transistor, and is configured to decouple and adjust odd harmonics and even harmonics. By connecting the decoupling unit between the bases of the first transistor and the second transistor in common-base configuration, odd harmonic component and even harmonic component can be independently adjusted, harmonic regulation can be realized without additionally matching input and output elements, circuit structure is simplified, and useful signal gain is improved; moreover, by independently adjusting the even harmonic component, common-mode component of the circuit can be adjusted on the premise of ensuring that differential-mode gain is not changed, that is, enhancement of common-mode rejection can be realized, and common-mode stability and comprehensive performance of the radio-frequency amplifier can be improved.

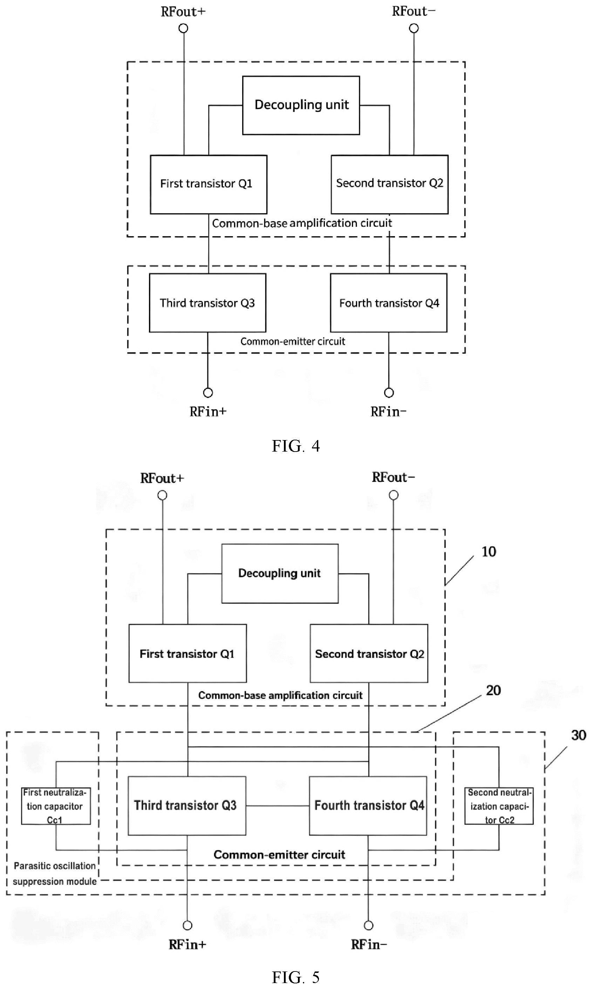

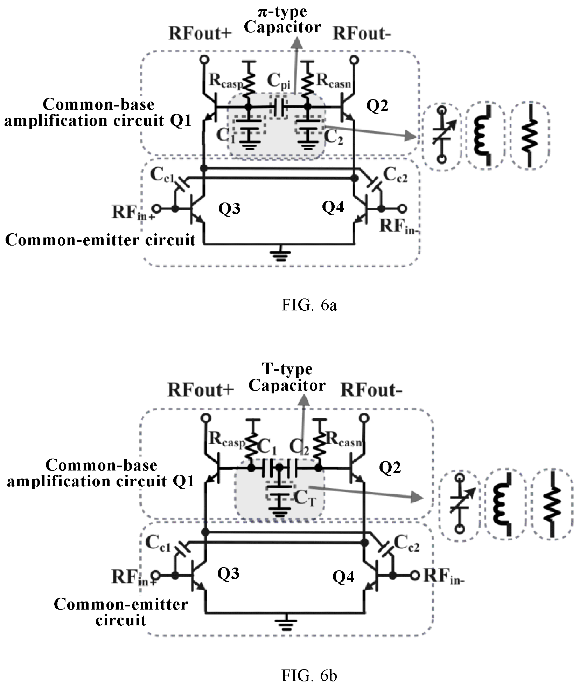

FIG. 4 is a block diagram of a radio-frequency amplifier according to an embodiment of the present disclosure, FIG. 6a is a schematic diagram of a radio-frequency amplifier with a π-type decoupling structure according to an embodiment of the present disclosure, and FIG. 6b is a schematic diagram of a radio-frequency amplifier with a T-type decoupling structure according to an embodiment of the present disclosure. As shown in FIG. 4, FIG. 6a, and FIG. 6b, the radio-frequency amplifier may further include a common-emitter circuit 20 in addition to the common-base amplification circuit 10, the common-emitter circuit 20 includes a third transistor Q3 and a fourth transistor Q4, and an emitter of the third transistor Q3 is connected to an emitter of the fourth transistor Q4; a collector of the third transistor Q3 is connected to the emitter of the first transistor Q1, and a collector of the fourth transistor Q4 is connected to the emitter of the second transistor Q2.

The third transistor Q3 and the fourth transistor Q4 have the same size, the common-emitter circuit 20 is in a form of a pseudo-differential transistor, the emitter of the third transistor Q3 and the emitter of the fourth transistor Q4 are connected to each other and are grounded, a base of the third transistor Q3 and a base of the fourth transistor Q4 are connected to radio frequency input terminals RFin+ and RFin- respectively, and the collector of the third transistor Q3 and the collector of the fourth transistor Q4 are connected to an input terminal of the common-base amplification circuit 10.

In order to further improve differential-mode stability and isolation, in some embodiments, as shown in FIG. 5, FIG. 6a, and FIG. 6b, the radio-frequency amplifier may further include a parasitic oscillation suppression module 30, which includes a first neutralization capacitor C_{C1} and a second neutralization capacitor C_{C2}, one terminal of the first neutralization capacitor C_{C1} is connected to the base of the third transistor Q3, and the other terminal is connected to the collector of the fourth transistor Q4; one terminal of the second neutralization capacitor C_{C2} is connected to the base of the fourth transistor Q4, and the other terminal is connected to the collector of the third transistor Q3. Through the above cross connection of the neutralization capacitors and the transistors in the common-emitter circuit, the differential-mode stability and isolation of the radio-frequency amplifier can be improved.

The neutralizing capacitor is relatively sensitive, and is merely effective within a relatively small capacitance range, and a capacitance value out of the range may cause self-oscillation of the amplifier and deterioration of common-mode stability to a certain extent. According to the embodiments of the present disclosure, the decoupling unit is combined with the parasitic oscillation suppression module 30, which can balance the differential-mode stability and the common-mode stability, and realize independent adjustment of the odd harmonic component and the even harmonic component.

In some embodiments, a capacitance value of the first neutralization capacitor is equal to that of the second neutralization capacitor. It should be noted that the capacitance values of the first neutralization capacitor and the second neutralization capacitor may be set to be different in order to further improve the common-mode stability and the performance of the radio-frequency amplifier, so as to adjust balance of the radio-frequency amplifier.

An embodiment of the present disclosure further provides an electronic device, including the radio-frequency amplifier as described above.

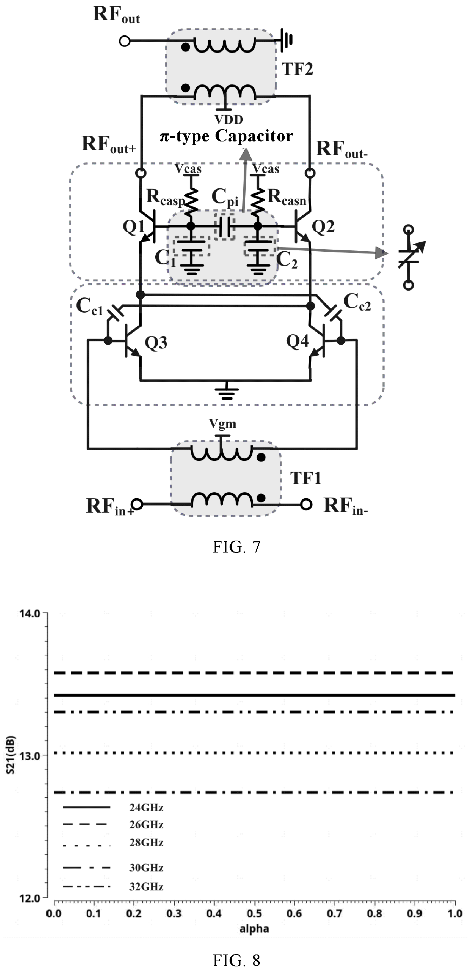

For clearly explaining the technical solutions in the embodiments of the present disclosure, a specific example is described below with reference to FIG. 7. As shown in FIG. 7, the radio-frequency amplifier includes the common-emitter circuit, the common-base amplification circuit, and the parasitic oscillation suppression module, and the common-base amplification circuit includes the π-type decoupling unit; in this example, the π-type decoupling unit is a π-type capacitor.

The common-base amplification circuit is formed by the transistors Q1 and Q2 which have the same size. The emitter of Q1 is connected to the collector of Q3 in the common-emitter circuit, and the collector of Q1 is connected to one terminal of a primary coil of an output transformer balun TF2; the emitter of Q2 is connected to the collector of Q4 in the common-emitter circuit; the collector of Q2 is connected to the other terminal of the primary coil of the output transformer balun TF2, a center tap of the primary coil of TF2 is connected to a power supply VDD for providing a direct current path for the circuit, one terminal of a secondary coil is grounded, and the other terminal is connected to radio frequency output. Impedance matching or power matching of an output port can be achieved by properly designing sizes, the numbers of turns, and coupling coefficients of the primary and secondary coils of the transformer TF2. The base of Q1 is connected to a bias voltage Vcas through the bias resistor Rcasp, the base of Q2 is connected to the bias voltage Vcas through the bias resistor Rcasn, and the bases of Q1 and Q2 are connected to two terminals of the π-type capacitor respectively.

The common-emitter circuit is formed by the transistors Q3 and Q4 which have the same size, differential radio frequency signals RFin+ and RFin- are connected to two terminals of a primary coil of a transformer TF1, two terminals of a secondary coil are used as input terminals of the common-emitter circuit, and are connected to the base of Q3 and the base of Q4 in the common-emitter circuit respectively, and a center tap of the secondary coil is connected to a bias voltage Vgm for providing direct current bias of the common-emitter circuit. The emitters of Q3 and Q4 are connected to each other and are grounded for providing a direct current path. The collector of Q3 is connected to the emitter of the transistor Q1 in the common-base amplification circuit, and the collector of Q4 is connected to the emitter of Q2 in the common-base amplification circuit. Impedance matching of an input port can be achieved by properly designing sizes, the numbers of turns, and coupling coefficients of the primary and secondary coils of the transformer TF1.

The π-type decoupling unit is formed by the capacitors C₁, C₂, and Cₚᵢ. In general, C₁=C₂. Balance of a differential circuit may be adjusted by setting C₁≠C₂, and harmonic energy of the circuit may be adjusted by adjusting values of C₁, C₂, and Cₚᵢ. One terminal of C₁ is connected to the base of the transistor Q1 in the common-base amplification circuit, and the other terminal of C₁ is connected to the ground; one terminal of Cₚᵢ is connected to the base of Q1, the other terminal is connected to the base of Q2; one terminal of C₂ is connected to the base of Q2, and the other terminal is connected to the ground.

The parasitic oscillation suppression module is formed by the neutralization capacitor C_{C1} and the neutralization capacitor C_{C2}. One terminal of the neutralization capacitor C_{C1} is connected to the base of the transistor Q3 in the common-emitter circuit, and the other terminal is connected to the collector of the transistor Q4 in the common - emitter circuit; one terminal of the neutralization capacitor C_{C2} is connected to the base of the transistor Q4 in the common-emitter circuit, and the other terminal is connected to the collector of the transistor Q3 in the common-emitter circuit. The cross connection forms a neutralization capacitor structure, and the differential-mode stability and isolation of the radio-frequency amplifier can be improved by adjusting magnitude of capacitance values of the neutralization capacitors C_{C1} and C_{C2}.

In the example illustrated by FIG. 7, it is derived from Cₜₒₜₐₗ=C+2Cₚᵢ that C1=C2=C=α₁*Cₜₒₜₐₗ , Cₚᵢ=0.5*(1-α₁)*Cₜₒₜₐₗ , and Cₜₒₜₐₗ=1p . When α₁=1, Cₚᵢ=0, the radio-frequency amplifier is equivalent to the conventional radio-frequency amplifier shown in FIG. 1b; when 0<α₁≤1, the radio-frequency amplifier serves as the novel radio-frequency amplifier provided in the present disclosure; when α₁>1, Cₚᵢ is equivalent to an inductor.

The differential radio frequency signals RFin+ and RFin- are respectively input from the bases of the common-emitter circuit. After part of transistor base-collector coupled signals is counteracted by the neutralization capacitors C_{C1} and C_{C2} to improve the differential-mode stability and isolation, the differential radio frequency signals RFin+ and RFin- are output from the collectors of the common-emitter circuit to the common-base amplification circuit. After subjected to harmonic processing by the π-type capacitor in the common-base amplification circuit, the differential radio frequency signals RFin+ and RFin- are output from the collectors of the common-base amplification circuit. The bias resistors Rcasp and Rcasn provide bias power supply for the common-base amplification circuit, a bias (not shown) of the common-emitter circuit is flexibly used based on an input matching type, and a power supply of the whole radio-frequency amplifier is powered by an output matching network, and may be powered by a differential inductor, a transformer, or a balun.

FIG. 8 is a schematic diagram illustrating variation of a differential-mode gain of the radio-frequency amplifier of FIG. 7 with an adjustment coefficient. In FIG. 8, the abscissa is the adjustment coefficient α₁ and the ordinate is the differential-mode gain. As shown in FIG. 8, the differential-mode equivalent capacitance Cₜₒₜₐₗ is not changed when α₁ is adjusted. Therefore, the differential-mode gain is not changed when α₁ is adjusted.

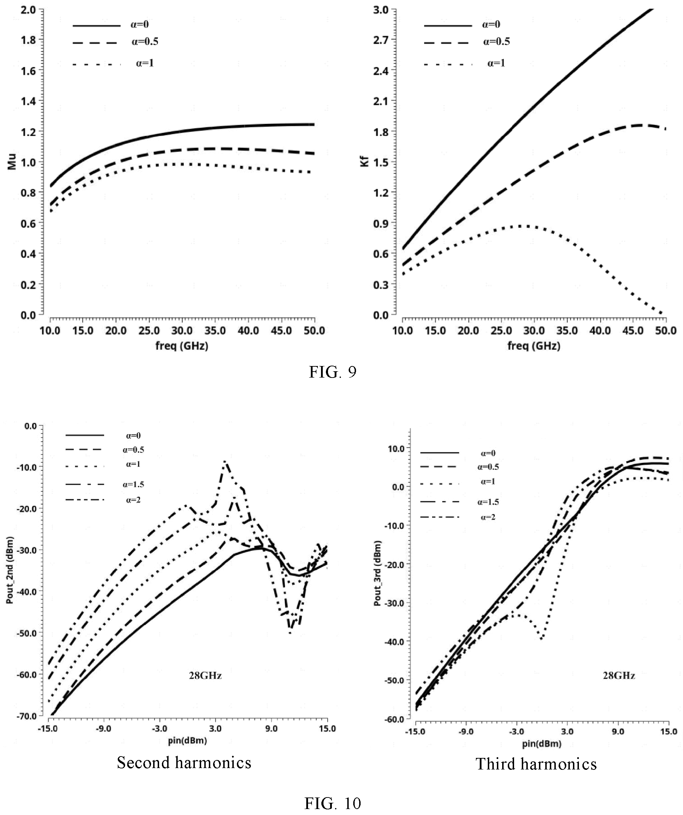

FIG. 9 is a schematic diagram illustrating variation of common-mode stability factors of the radio-frequency amplifier of FIG. 7 with an adjustment coefficient. In FIG. 9, the abscissa is frequency and the ordinate is a common-mode stability factor. FIG. 9 illustrates a comparison result of the common-mode stability of the radio-frequency amplifier provided in the embodiments of the present disclosure and the conventional radio-frequency amplifier under the same Cₜₒₜₐₗ, with α(α₁)=1 representing the conventional radio-frequency amplifier. As shown in FIG. 9, under the same equivalent capacitance Cₜₒₜₐₗ, by adjusting capacitance distributions of C₁, C₂, and Cₚᵢ, the common-mode stability factors Mu and kf of the circuit are both significantly improved, with Mu improved by 20% and kf improved by 121%.

FIG. 10 is a schematic diagram illustrating variation of harmonics with input power under different adjustment coefficients in the radio-frequency amplifier of FIG. 7. In FIG. 10, the abscissa is the adjustment coefficient α₁ and the ordinate is harmonic output power. FIG. 10 illustrates variation of second harmonics with the input power and variation of third harmonics with the input power under different first adjustment coefficients α(α₁) at the frequency point of 28 GHz. When α₁>1, the π-type capacitor is equivalent to an inductor. As can be clearly seen from FIG. 10, second harmonic components and third harmonic components can be adjusted by α₁, that is, under the condition that the equivalent total capacitance Cₜₒₜₐₗ is kept unchanged, the output harmonic components of the radio - frequency amplifier can be adjusted by reasonably allocating the capacitance values of C₁, C₂, and Cₚᵢ, and it can be seen from FIG. 10 that an adjustment range of the second harmonics and that of the third harmonics are both greater than 10 dB.

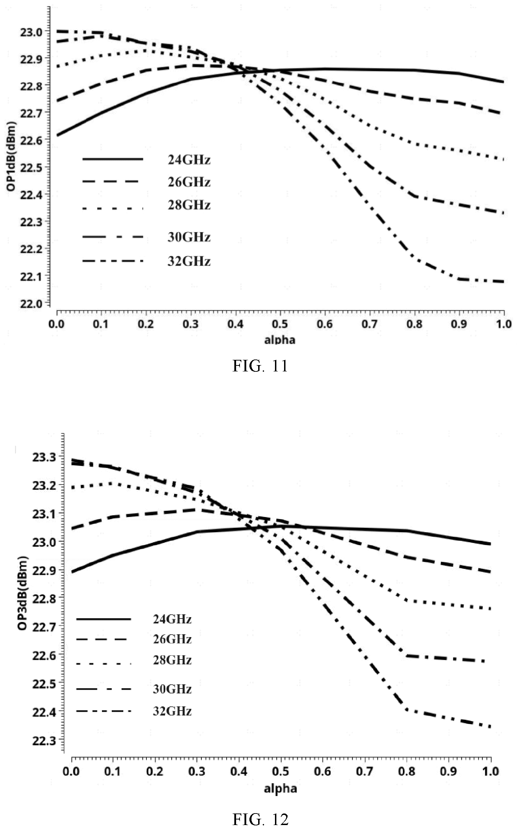

FIG. 11 is a schematic diagram illustrating variation of OP1dB of the radio-frequency amplifier of FIG. 7 with an adjustment coefficient, and FIG. 12 is a schematic diagram illustrating variation of OP3dB of the radio-frequency amplifier of FIG. 7 with an adjustment coefficient. In FIG. 11 and FIG. 12, the abscissa is the first adjustment coefficient α₁ and the ordinate is output power of useful signals. FIG. 11 and FIG. 12 illustrate variation of OP1dB (output a compression power of 1 dB) and variation of OP3dB (output a compression power of 3 dB) with the first adjustment coefficient α₁ at different frequency points. As can be seen from FIG. 11 and FIG. 12, by adjusting the value of the first adjustment coefficient α₁, OP1dB and OP3dB fluctuate to certain extent at each frequency point, and relatively uniform values of the output power are obtained when α₁ is in the range of 0.3 to 0.5.

The embodiments of the present disclosure provide the radio-frequency amplifier achieving enhancement of common-mode rejection and adjustable harmonics, which can improve the common-mode stability, and realize adjustable harmonic components. The decoupling unit in the common-base amplification circuit of the radio-frequency amplifier adopts the π-type capacitor or the T-type capacitor. In a case where the π-type capacitor is adopted, the base capacitance value Cₜₒₜₐₗ of the common-base amplification circuit in the conventional differential radio-frequency amplifier is reasonably distributed to the π-type capacitor in the radio-frequency amplifier, and Cₜₒₜₐₗ=C₁(or C₂)+2Cₚᵢ (in general, C₁=C₂) is met. Under the condition of ensuring that the differential -mode Cₜₒₜₐₗ is not changed, the ratio of C₁, C₂, and Cₚᵢ is allocated; in a case where the T-type capacitor is adopted, C₁=C₂=Cₜₒₜₐₗ , and C_{T}=αCₜₒₜₐₗ are ensured. The configuration of the decoupling unit can realize the enhancement of common-mode rejection and the adjustable harmonics of each order under the condition of ensuring that the differential-mode gain is not changed.

Depending on a main function of the circuit in a system, the π-type capacitor or the T-type capacitor can perform adjustment of the ratio correspondingly. For example, when applied to a power amplifier in a radio frequency transceiver system, the ratio of C₁, C₂, and Cₚᵢ in a π-type capacitor network is adjusted or C_{T} in a T-type capacitor network is adjusted to obtain the maximum OP1dB and Power Additional Efficiency (PAE); when applied to an LODA in the radio frequency transceiver system, the ratio of C₁, C₂, and Cₚᵢ in the π-type capacitor network is adjusted or C_{T} in the T-type capacitor network is adjusted to realize minimum harmonic output, and improve harmonic suppression capability.

In view of improvement to the stability of the radio-frequency amplifier, the embodiments of the present disclosure propose the technical solutions from the following two aspects. Firstly, the differential-mode stability and isolation are improved by adopting the neutralization capacitors. Secondly, by adjusting the ratio of C₁, C₂, and Cₚᵢ in the π-type capacitor, the common-mode component of the circuit can be adjusted accordingly without affecting differential-mode signals; by reducing C₁ and C₂ and increasing Cₚᵢ, the enhancement of common-mode rejection can be realized, and the common-mode stability can be improved; or, by adjusting C_{T} in the T-type capacitor, the common-mode component of the circuit can be adjusted accordingly, and the common-mode stability can be enhanced by using a low-Q capacitor C_{T}.

In view of independent adjustment to the odd/even harmonic component of the radio-frequency amplifier, according to the embodiments of the present disclosure, the odd harmonic component of the radio-frequency amplifier can be adjusted by adjusting the capacitance value of Cₜₒₜₐₗ in the π-type capacitor, and the even harmonic component of the radio-frequency amplifier can be independently adjusted by adjusting the ratio of C₁, C₂, and Cₚᵢ in the π-type capacitor; the odd harmonic component of the radio - frequency amplifier can be adjusted by adjusting the capacitance value of C ₜₒₜₐₗ in the π-type capacitor, and the even harmonic component of the radio-frequency amplifier can be independently adjusted by adjusting the capacitance value of C_{T} in the T-type capacitor. Thus, decoupling and adjustment of the odd and even harmonics are achieved.

The radio-frequency amplifier provided in the embodiments of the present disclosure can serve as various radio-frequency amplifiers in a radio frequency/millimeter wave communication system and a radar system. Illustratively, the radio-frequency amplifier provided in the embodiments of the present disclosure can serve as a power amplifier, a driver amplifier, a low noise amplifier, or a variable gain amplifier to amplify radio frequency signals, is not limited to radio frequency/millimeter-wave bands, and is also applicable to Sub-6G and terahertz frequency bands. The radio-frequency amplifier includes the differential input ports (RFin+ and RFin-) and the differential output ports (RFout+ and RFout-), the differential input ports are connected to output of a previous module through an input matching network, and the differential output ports input the amplified radio frequency signals to input of a next module through an output matching network. The embodiments of the present disclosure aim to improve the common-mode stability of various radio-frequency amplifiers, and adjust the harmonic components to improve the comprehensive performance of the radio-frequency amplifiers, so as to improve performance of the whole transceiver system.

It should be understood by those of ordinary skill in the art that the functional modules/units in all or some of the operations and the devices in the method disclosed above may be implemented as software, firmware, hardware, or suitable combinations thereof. If implemented as hardware, the division between the functional modules/units stated above does not necessarily correspond to the division of physical components; for example, one physical component may have a plurality of functions, or one function or operation may be performed through cooperation of several physical components. Some or all of the physical components may be implemented as software executed by a processor, such as a Central Processing Unit (CPU), a digital signal processor or a microprocessor, or may be implemented as hardware, or may be implemented as an integrated circuit, such as an application specific integrated circuit. Such software may be distributed on a computer-readable medium, which may include a computer storage medium (or a non-transitory medium) and a communication medium (or a transitory medium). As well known by those of ordinary skill in the art, the term "computer storage medium" includes volatile/non-volatile and removable/non-removable media used in any method or technology for storing information (such as computer-readable instructions, data structures, program modules or other data). The computer storage medium includes, but is not limited to, a Random Access Memory (RAM), a Read-Only Memory (ROM), an Electrically Erasable Programmable Read-Only Memory (EEPROM), a flash memory or other memory techniques, a Compact Disc Read Only Memory (CD-ROM), a Digital Versatile Disc (DVD) or other optical discs, a magnetic cassette, a magnetic tape, a magnetic disk or other magnetic storage devices, or any other medium which can be configured to store desired information and can be accessed by a computer. In addition, it is well known by those of ordinary skill in the art that the communication media generally include computer-readable instructions, data structures, program modules, or other data in modulated data signals such as carriers or other transmission mechanisms, and may include any information delivery medium.

The present disclosure discloses the exemplary embodiments using specific terms, but the terms are merely used and should be merely interpreted as having general illustrative meanings, rather than for the purpose of limitation. Unless expressly stated, it is apparent to those of ordinary skill in the art that the features, characteristics and/or elements described in connection with a particular embodiment can be used alone or in combination with the features, characteristics and/or elements described in connection with other embodiments. Therefore, it should be understood by those of ordinary skill in the art that various changes in forms and details can be made without departing from the scope of the present disclosure of the appended claims.

## Claims

1. A common-base amplification circuit, comprising a first transistor, a second transistor, and a decoupling unit,
wherein a base of the first transistor is connected to a base of the second transistor;
the decoupling unit is connected between the base of the first transistor and the base of the second transistor, and is configured to decouple and adjust odd harmonics and even harmonics.

2. The common-base amplification circuit of claim 1, wherein the decoupling unit comprises a first impedance element, a second impedance element, and a third impedance element;
the decoupling unit is further configured to adjust the odd harmonics by adjusting a target impedance parameter which is obtained based on an impedance parameter of the first impedance element, an impedance parameter of the second impedance element, and an impedance parameter of the third impedance element, and adjust, under the condition that the target impedance parameter is not changed, the even harmonics by adjusting a ratio of the impedance parameter of the first impedance element, the impedance parameter of the second impedance element, and the impedance parameter of the third impedance element.

3. The common-base amplification circuit of claim 2, wherein the first impedance element, the second impedance element, or the third impedance element is one of or any combination of: a capacitor, an inductor, and a resistor.

4. The common-base amplification circuit of claim 2 or 3, wherein the first impedance element, the second impedance element, and the third impedance element are arranged in a π configuration, one terminal of the first impedance element is connected to the base of the first transistor, and the other terminal of the first impedance element is grounded; one terminal of the second impedance element is connected to the base of the second transistor, and the other terminal of the second impedance element is grounded; the third impedance element is connected across the base of the first transistor and the base of the second transistor.

5. The common-base amplification circuit of any one of claims 2 to 4, wherein the first impedance element, the second impedance element, and the third impedance element are capacitors, and meet a condition of:Cₚᵢ=0.5*(1-α₁)*Cₜₒₜₐₗ , wherein Cₜₒₜₐₗ is a capacitance value of the decoupling unit, Cₚᵢ is a capacitance value of the third impedance element, α₁ is a first adjustment coefficient, and α₁≠1;
the decoupling unit is configured to adjust the even harmonics by adjusting the first adjustment coefficient under the condition that the capacitance value Cₜₒₜₐₗ of the decoupling unit is not changed.

6. The common-base amplification circuit of claim 2 or 3, wherein the first impedance element, the second impedance element, and the third impedance element are arranged in a T configuration, one terminal of the first impedance element is connected to the base of the first transistor, and the other terminal of the first impedance element is connected to one terminal of the second impedance element; the other terminal of the second impedance element is connected to the base of the second transistor; one terminal of the third impedance element is connected between the first impedance element and the second impedance element, and the other terminal of the third impedance element is grounded.

7. The common-base amplification circuit of claim 2, 3, or 6, wherein the first impedance element, the second impedance element, and the third impedance element are capacitors, and meet a condition of: C_{T}=α₂*Cₜₒₜₐₗ , wherein Cₜₒₜₐₗ is a capacitance value of the decoupling unit, C_{T} is a capacitance value of the third impedance element, and α₂ is a second adjustment coefficient;
the decoupling unit is configured to adjust the even harmonics by adjusting the second adjustment coefficient under the condition that the capacitance value C ₜₒₜₐₗ of the decoupling unit is not changed.

8. The common-base amplification circuit of any one of claims 2 to 7, wherein at least one of the first impedance element, the second impedance element, or the third impedance element is a variable impedance element or a fixed impedance element.

9. The common-base amplification circuit of any one of claims 2 to 8, wherein the impedance parameter of the first impedance element is equal to or different from the impedance parameter of the second impedance element.

10. A radio-frequency amplifier, comprising the common-base amplification circuit of any one of claims 1 to 9.

11. The radio-frequency amplifier of claim 10, further comprising a common-emitter circuit, the common-emitter circuit comprising a third transistor and a fourth transistor, and an emitter of the third transistor being connected to an emitter of the fourth transistor; a collector of the third transistor being connected to an emitter of the first transistor, and a collector of the fourth transistor being connected to an emitter of the second transistor.

12. The radio-frequency amplifier of claim 11, further comprising a parasitic oscillation suppression module, the parasitic oscillation suppression module comprising a first neutralization capacitor and a second neutralization capacitor, one terminal of the first neutralization capacitor being connected to a base of the third transistor, and the other terminal of the first neutralization capacitor being connected to the collector of the fourth transistor; one terminal of the second neutralization capacitor being connected to a base of the fourth transistor, and the other terminal of the second neutralization capacitor being connected to the collector of the third transistor.

13. The radio-frequency amplifier of claim 12, wherein a capacitance value of the first neutralization capacitor is equal to or different from a capacitance value of the second neutralization capacitor.

14. An electronic device, comprising the radio-frequency amplifier of any one of claims 10 to 13.
